# EUROPEAN PATENT APPLICATION

(11) **EP 4 379 814 A1**
(43) Date of publication of application: **05.06.2024**
(21) Application number: 22849444.9
(22) Date of filing: 25.07.2022
(51) Int. Cl.: H01L 29/82, H10N 50/85, H01P 3/08

(54) **SPIN WAVE EXCITATION/DETECTION STRUCTURE**

(30) Priority: 28.07.2021 JP 2021123390
(71) Applicant: Shin-Etsu Chemical Co., Ltd., Tokyo 100-0005 (JP); Goto, Taichi, Sendai-shi, Miyagi 980-8577 (JP)
(72) Inventor: INOUE, Mitsuteru, Toyohashi-shi, Aichi 441-8580 (JP); WATANABE, Toshiaki, Annaka-shi, Gunma 379-0195 (JP); GOTO, Taichi, Sendai-shi, Miyagi 980-8577 (JP)
(74) Representative: Mooser, Sebastian Thomas
(86) International application number: PCT/JP2022/028656
(87) International publication number: WO 2023/008383

(57) **Abstract**

The present invention provides a spin wave excitation/detection structure to excite and detect a spin wave. This structure includes a support substrate, a conductive film provided on the support substrate, an insulating magnetic film provided on the conductive film, and a conductive line provided on the insulating magnetic film. This provides the spin wave excitation/detection structure having a structure with high strength, the spin wave that can be excited with high intensity, and the spin wave that can be excited with broad frequency bandwidth.

## Description

### TECHNICAL FIELD

The present invention relates to a spin wave excitation/detection structure.

### BACKGROUND ART

With explosive increase in an amount of information handled by such as a recent internet, acceleration of a CPU, acceleration of intermediate and long-range communication thanks to RF (high frequency) and optical communication, increase in a data storage capacity, and miniaturization of each part have been developed rapidly. However, an improvement in a processing speed has bottlenecks in that (1) a heat generation problem due to performance improvement by further miniaturization is approaching physical limitation, (2) a development rate of data communication speed between the CPU and a memory (Latency) is slowing down. Concerning the above-described problem (1), replacement to a carrier with low power consumption has been called for. The above-described problem (2) has also become conspicuous, along with a recent development of peripheral technology.

For example, in a sensor group that can detect sensation at a comparable level with a human being (so-called artificial skin), if access by using a conventional electric device is enabled, the number of transistors becomes enormous, a control unit is enlarged, and a communication delay is caused at the same time. Moreover, regarding a three-dimensional display with high resolution for a medical field and an entertainment field, an expansion of a viewing angle (secured at approximately 45 degrees) allows multiple people to watch simultaneously. On the other hand, when this display is configured by an electric device, the number of transistors is still enormous. Consequently, communication delay or heat generation from a wiring cannot be ignored, thus, burnt out of the wiring or an unstable operation due to heat generated is concerned.

Thus, with an increasing number of situations where large numbers of elements are required and a rapid increase in the degree of integration, a CMOS-based system has become the bottleneck of an entire application regarding speed and miniaturization.

Regarding such a problem of a system in which a conventional CMOS is used, technology attempts to solve this problem using a spin wave.

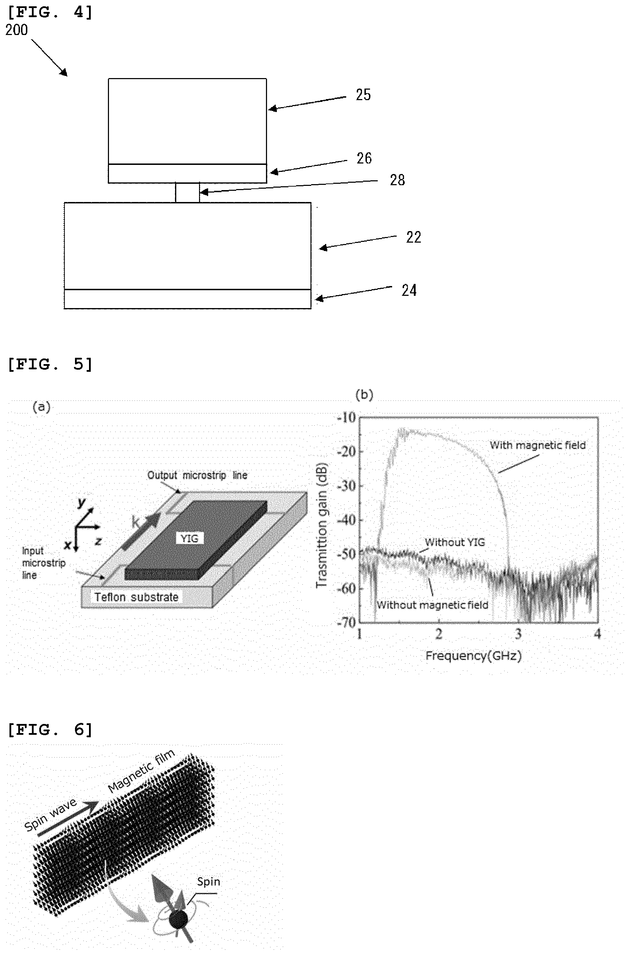

The spin wave (spin wave) is a phase wave generated by magnetization (spin) in a magnetic material. This wave is also called a magnetostatic wave (magnetostatic wave). In the magnetic material, a large number of spins are contained, as shown in FIG. 6. The plane where the timing (phase) of the rotation of these spins is aligned creates a wavefront. When the wavefront propagates, information is transmitted. This is the spin wave, and information can be transmitted without a charge transfer. The spin wave is a phenomenon related only to the magnetism of a material and not to the electrical properties. In other words, this wave propagates as long as the magnetic material is used, regardless of whether an electric conductor or an insulator is used. Consequently, by using the insulator, the wiring, in which an electric current does not flow through, but the spin wave propagates, can be produced. Moreover, this spin wave is the wave having a GHz (gigahertz) band, thus fast enough for information processing.

In this way, since the spin wave is a method to transmit information with no charge transfer being required, thus has attracted attention as a potential information processing device with ultra-low power consumption in the next generation. Basic logic circuits such as an XNOR circuit [see Non Patent Document 1], an AND circuit, and an OR circuit [see Non Patent Document 2] are already in the research stage of being demonstrated. The basic elements have been demonstrated, thus, more complex and practical circuits and applications are proposed, demonstrated, and patented in the present situation. Recently, a study has disclosed a computation showing that a compact address decoder can be manufactured by using the spin wave (see Patent Document 1). In addition to the development of functionality, miniaturization of size has also progressed. Miniaturization to a micrometer and a nanoscale is considered to move on.

Several methods exist to generate the spin wave, but currently, a technique to generate the spin wave using the electric current is mainstream.

Patent Document 2 discloses the spin wave excitation structure of a coplanar waveguide type (a complete type in one layer). This spin wave excitation structure (an antenna) is a type in which a copper line for a signal level and a copper line for a ground level are formed in one layer. A structure, as disclosed in Patent Document 2, allows an input of high-frequency electrical signals. As described above, this structure is called the coplanar waveguide structure and is a widely known structure. An antenna part can be produced in a completed single layer and can be minimized to a nanometer scale, thus widely used. However, the spin wave (magnetostatic wave) that can be generated has a problem in which the frequency bandwidth is narrow.

Patent Document 3 discloses the spin wave excitation structure of a microstrip line type. The microstrip line is a structure in which a single current-flowing copper line (signal level) is placed on a medium through which the spin wave propagates, and a ground level is placed below the medium (YIG (yttrium iron garnet) is shown as an example in Patent Document 3) through which the spin wave propagates.

The microstrip line type structure, disclosed in Patent Document 3, has an advantage where the spin wave that can be generated has a wide band. On the other hand, the signal level and the ground level step over YIG and form a multilevel structure, thus, the integration is difficult to achieve.

With advancement of the miniaturization and integration, as making the microstrip line narrower, a distance between the signal level and the ground level (= a thickness of YIG) is intact, thus, a high-frequency rotating magnet field cannot be produced well in the medium in which the spin wave propagates, and thus an intensity of the spin wave decreases. When the signal level and ground level are close, and the more YIG is interposed between, the spin wave intensity that can be excited is increased.

When making the microstrip line narrower, thinning YIG simultaneously can be considered a technique to maintain the intensity of the spin wave. However, when YIG has a thickness of 1 micrometer or less, YIG is unable to self-support (YIG may crack). Consequently, YIG is typically handled in a state of being placed on a substrate having a thickness of 100 micrometer class, thus, a study of structure is conducted within such range.

Specifically, a conductor (often the copper line) called the microstrip line (Microstrip line) is used, as shown in FIG. 5(a). Copper is film-formed on an entire surface of a Teflon (registered trademark) substrate of a lower side of the Teflon (registered trademark) substrate (Teflon substrate). The thickness of the copper film is about 10 um. The copper line on the Teflon (registered trademark) substrate has a width of about 10 um and a thickness of about 10 um, too. When an electric current is applied to this line, a rotating magnetic field that rotates at a speed of about GHz is generated around this copper line. Under a condition when a direct current magnetic field is applied to a region where this rotating magnetic field is generated, and if a magnetic insulator (a material called YIG in FIG. 5(a)) is placed on the region, the spin wave is excited by the rotating magnetic field. As a result, the spin wave is propagated from one microstrip line (an input microstrip line, Input microstrip line) to another microstrip line (an output microstrip line, Output microstrip line). At the point of the output microstrip line, reversely, the rotating magnetic field generated by the spin wave generates an electric current in the microstrip line. In other words, making the electric current flow excites the spin wave. Then, the propagation of the spin wave is generated, and then an operation is performed during the propagation, and then a result of the operation is propagated. Then, a conversion of the spin wave to the electric current is performed, and the result is detected as an electric signal. This means that a spin wave propagation spectrum can be obtained, as shown in the "with magnetic field" line in FIG. 5(b). "Without YIG" in FIG. 5(b) shows a spectrum without YIG in a structure in FIG. 5(a), "without magnetic field" in FIG. 5(b) shows a spectrum when the direct current magnetic field is not applied in a structure in FIG. 5(a). Moreover, referring to FIG. 5(a), the part of the input microstrip line is the spin wave excitation structure, and the part of the output microstrip line is the spin wave detection structure.

### CITATION LIST

### PATENT LITERATURE

Patent Document 1: JP 2017-162937 A
Patent Document 2: JP 2006-504345 A
Patent Document 3: JP H1-91514 A

### NON PATENT LITERATURE

Non Patent Document 1: Taichi Goto, Takuya Yoshimoto, Bungo Iwamoto, Kei Shimada, Caroline A. Ross, Koji Sekiguchi, Alexander B. Granovsky, Yuichi Nakamura, Hironaga Uchida and Mitsuteru Inoue, "Three port logic gate using forward volume spin wave interference in a thin yttrium iron garnet film", Scientific Reports, 9, 16472 (2019/11/11).

Non Patent Document 2: Naoki Kanazawa, Taichi Goto, Koji Sekiguchi, Alexander B. Granovsky, Caroline A. Ross, Hiroyuki Takagi, Yuichi Nakamura, Hironaga Uchida and Mitsuteru Inoue, "The role of Snell's law for a magnonic majority gate", Scientific Reports, 7, 7898 (2017/08/11).

### SUMMARY OF INVENTION

### TECHNICAL PROBLEM

As described above, spin wave devices, attracting attention as the latest information processing devices, also have a problem. This is a low intensity of a spin wave.

A currently used spin wave excitation structure using electricity (also known as a transducer or an antenna) (which can also be a spin-wave detection structure, as described above) is shown in FIG. 4 when a cross-sectional view is illustrated. A conventional spin wave excitation/detection structure 200 has a structure in which a copper film 24 is under a dielectric substrate 22, and a YIG film 26 with gadolinium gallium garnet substrate 25 is mounted on a copper line 28. This is not suited for miniaturization and integration. This is because if the miniaturization is achieved by a method according to simple scale down, an excitation efficiency becomes significantly low, and a bandwidth becomes significantly narrow.

The present invention has been made in view of the above-described problem. An object of the present invention is to provide a spin wave excitation/detection structure having a structure with high strength, the spin wave that can be excited with high intensity, and the spin wave that can be excited with broad frequency bandwidth.

### SOLUTION TO PROBLEM

To achieve the object, the present invention provides a spin wave excitation/detection structure to excite and detect a spin wave, comprising:
a support substrate;
a conductive film provided on the support substrate;
an insulating magnetic film provided on the conductive film; and
a conductive line provided on the insulating magnetic film.

Such a spin wave excitation/detection structure has a structure with high strength, the spin wave that can be excited with high intensity. Moreover, frequency bandwidth of the spin wave that can be excited is broad.

Note that the insulating magnetic film is preferably a magnetic garnet. Furthermore, the insulating magnetic film is preferably an yttrium iron garnet.

By using these kinds of insulating magnetic films, an excellent spin wave can be excited. In addition, the detection of the spin wave can also be performed without any problem.

In addition, the conductive film and the conductive line can contain at least any one of copper, aluminum, gold, silver, platinum, iron, transparent conductor, superconductor, graphene, and magnetic material with conductivity.

In the inventive spin wave excitation/detection structure, the above kinds of conductors, as well as copper, can be used as a conductor component.

Furthermore, the support substrate can be at least any one of a silicon substrate, a dielectric substrate, a conductive substrate, an insulating substrate, a magnetic substrate, a nonmagnetic substrate, a wood substrate, and a stone substrate.

In the inventive spin wave excitation/detection structure, the silicon substrate or other substrates of the kinds described above can be used for the support substrate.

In addition, the insulating magnetic film preferably has a thickness of 10 um or less.

Furthermore, the conductive line preferably has a thickness of 1 um or less and a width of 5 um or less.

Additionally, the conductive film preferably has a thickness of 1 um or less.

Moreover, the support substrate preferably has a thickness of 100 um or more and 500 um or less.

Dimensions of a component of the inventive spin wave excitation/detection structure are preferably like the above and can be miniaturized.

### ADVANTAGEOUS EFFECTS OF INVENTION

The inventive spin wave excitation/detection structure has a structure with high strength, and the spin wave that can be excited with high intensity. In addition, a frequency bandwidth of the spin wave that can be excited is broad. In more detail, the inventive spin wave excitation/detection structure has the insulating magnetic film and the support substrate via the conductive film and a characteristic of a wide excitation bandwidth of the microstrip line. In addition, the structure has the signal level and the ground level nearby, and the insulating magnetic film sandwiched between these levels as a propagating region for the excited spin wave, thus, the intensity of the spin wave excited is high. Moreover, the insulating magnetic film is bonded to the support substrate via the conductive film, which has an effect on high mechanical strength of the structure and an ability for handling.

### BRIEF DESCRIPTION OF DRAWINGS

FIG. 1 is a view illustrating an example of a schematic cross-sectional view of a spin wave excitation/detection structure according to the present invention.
FIG. 2 is a view illustrating a schematic cross-sectional view of a spin wave excitation/detection structure used in Example.
FIG. 3 is a graph showing spin wave propagation spectra in Example and Comparative Example, respectively.
FIG. 4 is a view illustrating a schematic cross-sectional view of a spin wave excitation/detection structure used in Comparative Example.
FIG. 5(a) is a view illustrating a perspective view of a spin wave excitation/detection structure of a conventional microstrip type, and (b) is spin wave propagation spectra in this structure.
FIG. 6 is a view illustrating a schematic view to describe a spin wave.

### DESCRIPTION OF EMBODIMENTS

Hereinafter, embodiments of the present invention will be described. However, the present invention is not limited thereto.

As described above, a currently used spin wave excitation structure (also known as a transducer or an antenna) using electricity, shown in FIG. 4, is not suitable for miniaturization and integration. Since an excitation efficiency becomes extremely low and bandwidth becomes extremely narrow when miniaturization is done by a simple scaling down method. Specifically, when a copper line 28 of the upper portion is made thinner and narrower for miniaturization and integration, an intensity of a spin wave decreases. This is because the copper line 28 of the upper portion and a copper film 24 of the lower portion are too far. Consequently, a technique to make a dielectric substrate 22 portion thinner comes to mind, but this makes a rotating magnetic field unable to generate in a YIG film 26 of the upper portion. Therefore, the YIG film 26 needs to be located between the copper line 28 of the upper portion and the copper film 24 of the lower portion. Furthermore, if a sample is too thin, the sample falls apart thus a substrate (the dielectric substrate 22) is necessary.

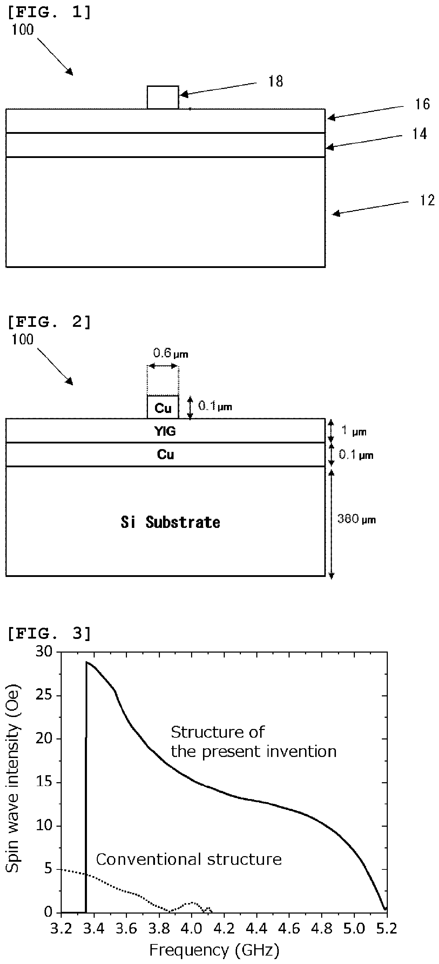

The present inventors devised a structure shown in FIG. 1 to be useful, based on a problem with the conventional spin wave excitation/detection structure 200 shown in FIG. 4, and found out the usefulness through calculations. Consequently, the following inventive structure is proposed.

FIG. 1 shows an example of the inventive spin wave excitation/detection structure 100. The spin wave excitation/detection structure 100 can excite the spin wave. Moreover, this can also detect the spin wave. The spin wave excitation/detection structure 100 includes a support substrate 12, a conductive film 14 provided on the support substrate 12, an insulating magnetic film 16 provided on the conductive film 14, and a conductive line 18 provided on the insulating magnetic film 16. In other words, the support substrate 12, the conductive film 14, the insulating magnetic film 16, and the conductive line 18 are laminated in this order.

With the conductive line 18 of the upper portion as an electric signal level and the conductive film 14 of the lower portion as an electric ground level, supplying a high-frequency signal in the gigahertz band excites the spin wave within the insulating magnetic film 16.

When the spin wave excitation/detection structure 100 shown in FIG. 1 is manufactured, for example, the structure can be manufactured by providing and bonding the insulating magnetic film 16 on which the conductive line 18 is film-formed and the support substrate 12 on which the conductive film 14 is film-formed. For example, a YIG on which a Cu line is film-formed and a Si substrate on which a Cu film is film-formed are provided and then bonded, this allows the manufacturing of the inventive structure. Moreover, the insulating magnetic film 16 can be epitaxially grown on another growth substrate, not shown in FIG., and then the growth substrate can be removed after the bonding. For example, a single crystal of yttrium iron garnet Y₃Fe₅O₁₂ (YIG) grown by liquid epitaxial growth on a nonmagnetic substrate such as gadolinium gallium garnet Gd₃Ga₅O₁₂ (GGG) can be used as the insulating magnetic film 16, in such a case the GGG substrate can be removed by such as grinding.

At this point, in the spin wave excitation/detection structure 100 in FIG. 1, the insulating magnetic film 16 is preferably made of a magnetic garnet. In particular, the insulating magnetic film 16 is preferably made of the yttrium iron garnet (YIG). Furthermore, the yttrium iron garnet can be a material based on Y₃Fe₅O₁₂, with a Y portion or a Fe portion being replaced by other elements. By using the magnetic garnet, especially the yttrium iron garnet, as the insulating magnetic film 16, an excellent spin wave can be excited. Moreover, the detection of the spin wave can be performed without any problems. The thickness of the insulating magnetic film 16 is preferably 10 um or less, more preferably 5 um or less, and particularly preferably 1 um or less. This way, the insulating magnetic film 16 can be as thin as 10 um or less in the inventive spin wave excitation/detection structure 100.

In the spin wave excitation/detection structure 100 in FIG. 1, the conductive film 14 and the conductive line 18 can contain at least any one of copper, aluminum, gold, silver, platinum, iron, transparent conductor, superconductor, graphene, and magnetic material with conductivity. Copper is particularly preferred among these. Moreover, other conductors can be used for the material for the conductive film 14 and the conductive line 18, for example, carbon nanotube or organic conductive material can be used. Furthermore, the material of the conductive film 14 and the conductive line 18 is preferred to have higher conductivity than the support substrate 12 or the insulating magnetic film 16. The components of the conductive film 14 and the conductive line 18 may be the same or different.

Among these, the conductive line 18 preferably has a thickness of 1 um or less and a width of 5 um or less. A thickness of 0.5 um or less is even more preferable, and 0.1 um or less is particularly preferable. Moreover, a width of 2 um or less is even more preferable, and 0.5 um or less is particularly preferable. Furthermore, a lower limit of the thickness of the conductive line 18 is not particularly limited; however, if the thickness is too thin, the line is separated and split, and conductivity cannot be maintained, thus, 0.01 um or more is preferable. Moreover, one conductive line 18 of the upper portion is sufficient. However, the lines may be two or more.

In addition, the conductive film 14 preferably has a thickness of 1 um or less. The thickness is even more preferably 0.5 um or less, and 0.1 um or less is particularly preferable. Moreover, a lower limit of the thickness of the conductive film 14 is not particularly limited; however, if the thickness is too thin, the film is separated and split, and conductivity cannot be maintained. Thus, 0.01 um or more is preferable.

Additionally, in the spin wave excitation/detection structure 100 in FIG.1, the support substrate 12 can be at least any one of a silicon substrate, a dielectric substrate, a conductive substrate, an insulating substrate, a magnetic substrate, a nonmagnetic substrate, a wood substrate, and a stone substrate. In this way, various support substrates can be used. Among these, the silicon substrate can be obtained inexpensively and of excellent quality and is preferred as the support substrate 12. As for the insulating substrate, glass, quartz, sapphire, aluminum nitride, and alumina, for example, can be exemplified. Regarding the nonmagnetic substrate, a paramagnetic garnet substrate can also be used. A thickness of support substrate 12 is preferably 100 um or more and 500 um or less. When the support substrate 12 has a thickness of 100 um or more, the structure has high mechanical strength and easier handling; moreover, when the support substrate 12 has a thickness of 500 um or less, sufficient mechanical strength can be secured in the structure and is adequate.

Measurements of a component of the inventive spin wave excitation/detection structure 100 are preferably as enumerated above and can be miniaturized.

As described above, the inventive spin wave excitation/detection structure is expected to become an indispensable component as an excitation structure of the spin wave (a conversion element between electricity and the spin wave) in a spin wave computer, which is said to create a next-generation CPU.

The spin wave is a phase wave that propagates with an electron in a state of being fixed in place. Thus, in theory, a loss called a Joule heating loss that is supposed to be generated by charge transfer is zero. Moreover, YIG, in particular, is an insulator and does not generate an eddy current because of a magnetic oxide material. In this way, the spin wave has no loss in theory within both elements of a stationary electric current and an eddy current and has the potential to replace all of the wiring, and logic elements, such as NAND or NOR, that CMOS has realized. That is to say, the realizability of a cold computer without heat generation is expected in combination with nanotechnology.

A ripple effect of the inventive spin wave excitation/detection structure toward related fields includes the following.

### (1) Computer

The ripple effect affects all fields where computers are currently used, and device fields where such as CPUs and other arithmetic elements are mounted. In particular, useful in this regard is a situation where the computer is required at a millimeter or a micrometer scale. For example, a sensor and a microchip, which are increasingly used in a mobile device, a wearable device, and such as household appliances, are included.

### (2) High Frequency, wireless, communications field

The spin wave is the same as a microwave in light of a responsive wave of the order of GHz; however, a conversion to the wave propagating into the magnetic field makes a wavelength shorten in the order of a hundredfold or more. Considering this from the device (the element) size, this means that an entire chip can be made a hundredfold smaller. Conventionally, the miniaturization of an analog high-frequency device has not progressed much, and the device has a size far from being portable. Therefore, the realization of spin wave devices, including a spin wave phase modulation element, is expected to lead to the miniaturization of a high-frequency device.

### EXAMPLE

Hereinafter, the present invention will be specifically described with reference to Example and Comparative Example of the present invention. However, the present invention is not limited to these Examples.

### [Comparative Example]

A structure having a conventional structure, in FIG. 4, was manufactured. A dielectric substrate 22 had a thickness of 500 µm, a copper film 24 had a thickness of 10 um, a YIG film 26 had a thickness of 10 um, and a copper line 28 had a thickness of 10 um and a width of 10 um. The parameters for each material were as follows.

**[Table 1]**

| Components | Materials | Parameters |
|---|---|---|
| Insulating magnetic film | YIG | Relative permittivity: 15.3 Saturation magnetization: 1800 Gauss |
| | | Damping constant : 2.4×10⁻⁴ |
| | | External magnetic field: range from 500 Oe to 1500 Oe |
| | | Direction of external magnetic field: from bottom to top of cross-sectional view |
| Conductive film and conductive line | Cu | Conductivity : 5.96×10⁷ S/m |
| Dielectric substrate | Teflon substrate | Relative permittivity: 4.4 Dielectric loss Tanδ=0.02 |

A spin wave spectrum, obtained from a spin wave excitation/detection structure shown in FIG. 4, was calculated. A "conventional structure" in FIG. 3 represents this.

From FIG. 3, a spin wave intensity and a spin wave bandwidth were obtained, as shown below, respectively.
· The spin wave intensity: 1.17 Oe (a value of the spin wave intensity at 4.0 GHz, an operating frequency).
· The spin wave bandwidth: 0.243 GHz (representing a frequency range from 4.0 GHz, the operating frequency, to the frequency when the spin wave intensity reached half value).
When a value in which these two values are multiplied is defined as a performance index, the index is indicated below:
· The performance index: 0.285 GHz·Oe

### [Example]

A spin wave excitation/detection structure in FIG. 2, the inventive structure, was manufactured. The structure in FIG. 2 prescribed each material of the structure in FIG. 1 and had a dimension shown in FIG. 2. A parameter of each material is shown below.

**[Table 2]**

| Components | Materials | Parameters |
|---|---|---|
| Insulating magnetic film | YIG | Relative permittivity: 15.3 Saturation magnetization: 1800 Gauss |
| | | Damping constant : 2. 4×10⁻⁴ |
| | | External magnetic field: Range from 500 Oe to 1500 Oe |
| | | Direction of external magnetic field: from bottom to top of cross-sectional view |
| Conductive film and conductive line | Cu | Conductivity : 5.96×10⁷ S /m |
| Support substrate | Si substrate | Relative permittivity : 12 Conductivity: 50 S/m |

A spectrum of a spin wave obtainable from a structure in FIG. 2 was calculated. "Structure of the present invention" in FIG. 3 indicated this.

From FIG. 3, a spin wave intensity and a spin wave bandwidth were able to be obtained. Each was as follows.
· The spin wave intensity: 15.3 Oe (a value of the spin wave intensity at 4.0 GHz, an operating frequency).
· The spin wave bandwidth: 1.62 GHz (representing a frequency range from 4.0 GHz, the operating frequency, to the frequency when the spin wave intensity reached half value).
When a value in which these two values are multiplied is defined as a performance index, the index is indicated below:
· The performance index: 24.8 GHz·Oe

The spin wave intensity of Example 1 is 15 times larger than a conventional structure of Comparative Example 1, the bandwidth is 8 times larger, and the performance index is 6 times larger, indicating significant improvement and usefulness.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A spin wave excitation/detection structure to excite and detect a spin wave, comprising:
a support substrate;
a conductive film provided on the support substrate;
an insulating magnetic film provided on the conductive film; and
a conductive line provided on the insulating magnetic film.

2. The spin wave excitation/detection structure according to claim 1, wherein
the insulating magnetic film is a magnetic garnet.

3. The spin wave excitation/detection structure according to claim 2, wherein
the insulating magnetic film is an yttrium iron garnet.

4. The spin wave excitation/detection structure according to any one of claims 1 to 3, wherein
the conductive film and the conductive line contain at least any one of copper, aluminum, gold, silver, platinum, iron, transparent conductor, superconductor, graphene, and magnetic material with conductivity.

5. The spin wave excitation/detection structure according to any one of claims 1 to 4, wherein
the support substrate is at least any one of a silicon substrate, a dielectric substrate, a conductive substrate, an insulating substrate, a magnetic substrate, a nonmagnetic substrate, a wood substrate, and a stone substrate.

6. The spin wave excitation/detection structure according to any one of claims 1 to 5, wherein
the insulating magnetic film has a thickness of 10 um or less.

7. The spin wave excitation/detection structure according to any one of claims 1 to 6, wherein
the conductive line has a thickness of 1 um or less and a width of 5 um or less.

8. The spin wave excitation/detection structure according to any one of claims 1 to 7, wherein
the conductive film has a thickness of 1 um or less.

9. The spin wave excitation/detection structure according to any one of claims 1 to 8, wherein
the support substrate has a thickness of 100 um or more and 500 um or less.
